# EUROPÄISCHE PATENTSCHRIFT

(11) **EP 1 570 102 B1**
(45) Veröffentlichungstag und Bekanntmachung des Hinweises auf die Patenterteilung: **09.08.2006**
(21) Anmeldenummer: 03767466.0
(22) Anmeldetag: 27.11.2003
(51) Int. Cl.: C23C 14/02, C25D 5/36

(54) **VERFAHREN ZUM BESCHICHTEN VON KOLBENRINGEN FÜR VERBRENNUNGSMOTOREN**
METHOD FOR COATING PISTON RINGS FOR INTERNAL COMBUSTION ENGINES
PROCEDE PERMETTANT D'APPLIQUER UN REVETEMENT SUR DES SEGMENTS DE PISTON POUR MOTEURS A COMBUSTION INTERNE

(30) Priorität: 30.11.2002 DE 10256063
(43) Veröffentlichungstag der Anmeldung: 07.09.2005
(73) Patentinhaber: MAHLE GMBH, D-70376 Stuttgart (DE)
(72) Erfinder: ISSLER, Wolfgang, 71409 Schwaikheim (DE)
(74) Vertreter: Pohle, Reinhard
(86) Internationale Anmeldenummer: PCT/DE2003/003930
(87) Internationale Veröffentlichungsnummer: WO 2004/050937

(56) Entgegenhaltungen:
- EP-A- 0 702 097
- DE-A- 19 548 931
- PATENT ABSTRACTS OF JAPAN Bd. 0151, Nr. 05 (M-1092), 13. März 1991 (1991-03-13) & JP 3 000954 A (ISUZU MOTORS LTD), 7. Januar 1991 (1991-01-07)

## Beschreibung

Die Erfindung betrifft ein Verfahren zum Beschichten eines aus Stahl oder Gusseisen bestehenden Kolbenringes für Verbrennungsmotoren, bei dem mindestens die Lauffläche des Kolbenringes mit einer Verschleiß- oder Korrosionsschutzschicht durch einen Beschichtungsprozess versehen wird.

Es ist allgemein bekannt, dass zur Verlängerung der Lebensdauer von Verbrennungsmotoren die Gleitflächen der Laufpartner Kolbenring/Zylinder mit einer verschleißfesten Schicht aus Metallkarbid oder Metallnitrid, wie Titancarbid (TiC), Titannitrid (TiN) oder Chromnitrid (CrN, Cr₂N), versehen werden. Das Aufbringen derartiger Schichten erfolgt meist durch Ionenbeschichtungsprozesse, speziell durch physikalische Dampfabscheidung (PVD), wie beispielsweise in der DE 196 30 149 C2 und EP 0 702 097 A1 beschrieben, durch chemische Dampfabscheidung (CVD) gemäß JP 03000954AA, oder durch einen galvanischen Beschichtungsprozess gemäß DE 195 48 931 A1. Ziel der Laufflächenbeschichtung ist es, die Beständigkeit der Beschichtung gegen Abrieb, Festfressen, Abschälen und Abblättern zu verbessern, um den steigenden thermischen Beanspruchungen im Motorbetrieb gerecht zu werden. Trotz verschiedener Maßnahmen, welche die vorgenannten Beständigkeiten verbessern sollen, beispielsweise in der DE 41 12 422 C2 durch einen auf einem Trägermaterial ausgebildeten abriebfesten Überzug, der CrN enthält und dessen Stickstoffkonzentration von der Grenzfläche zwischen dem Trägermaterial und Überzug in Richtung äußere Oberfläche kontinuierlich abnimmt, zeigt sich im Motorbetrieb, dass die CrN, Cr₂N, TiN oder TiC- Schichten weiterhin zum Abschälen neigen. Als Ursache wird bisher angenommen, dass die PVD bzw. galvanischen Beschichtungen hohe Eigenspannungen aufweisen und dadurch ihre Adhäsion zum Trägermaterial schlecht ist. Wenn also eine dicke Beschichtung eingesetzt wird, sollte diese im Betrieb dazu neigen sich abzuschälen. Tatsächlich jedoch wird festgestellt, dass das Abschälen nicht bis zum Kolbenring als Träger der Beschichtung reicht oder, wenn der Kolbenring nitriert ist, nicht bis zur Nitridschicht erfolgt, sondern die Abschälkante bzw. Trennungsriss verläuft innerhalb der CrN, Cr₂N, TiN bzw. TiC-Beschichtung, also fast parallel zum Träger. Damit können Maßnahmen, die nur auf die Vermeidung schlechter Haftfestigkeit gerichtet sind ein Abschälen nicht verhindern, da nach gängiger Theorie der Abriss bis zum jeweiligen Beschichtungsträger reichen müsste. Offensichtlich scheinen Maßnahmen erfolgreich zu sein, welche die Eigenspannungen der aufgebrachten Verschleißschicht besser berücksichtigen.

Aufgabe der Erfindung ist es deshalb, eine Verschleiß- oder Korrosionsschutzschicht so auf die Lauffläche eines Kolbenringes eines Verbrennungsmotors aufzubringen, dass geringe Eigenspannungen innerhalb der Beschichtung des im Zylinder eingebauten Kolbenringes bzw. unter Belastungsbedingungen im Motorbetrieb auftreten.

Erfindungsgemäß wird die Aufgabe dadurch gelöst dass mittels eines Ionenbeschichtungs-Prozesses oder galvanischen Prozesses , mindestens die Lauffläche eines Kolbenringes mit einer Verschleiß- oder Korrosionsschutzschicht versehen wird, in dem in einem ersten Schritt die Beschichtungsparameter eingestellt und fixiert werden, nachfolgend ein unbeschichteter Kolbenring mit einer Vorspannung beaufschlagt wird, so dass dieser einen vorbestimmten Kolbenringdurchmesser aufweist, in einem weiteren Schritt des PVD-Beschichtungsprozesses mit den Parametern gemäß dem ersten Schritt durchgeführt wird, wobei danach die erzielte Schichteigenspannung der Verschleiß- oder Korrosionsschutzschicht durch eine Röntgendiffraktionsmessung ermittelt wird. In einem weiteren Verfahrensschritt werden neue zu beschichtende Kolbenringe mit einer Zug- oder Druckvorspannung in Abhängigkeit der gemessenen Schichteigenspannung beaufschlagt und anschließend mit den Beschichtungsparametern des ersten Verfahrensschrittes beschichtet. Insbesondere wird bei einer Ausbildung einer Druckeigenspannung der Verschleiß- oder Korrosionsschutzschicht der Kolbenring mit einer Druckvorspannung während der Beschichtung und bei einer Zugeigenspannung der Schicht mit einer Zugvorspannung während der Beschichtung beaufschlagt. Vorteilhaft erfolgt dabei die Beaufschlagung des Kolbenringes mit einer Druckvorspannung an der Lauffläche, indem die Maulweite am Kolbenringstoß mit geeigneten Mitteln auf ein größeres Maß gebracht wird und bei Beaufschlagung mit einer Zugvorspannung, in dem der Kolbenring durch geeignete Mittel auf einen kleineren Durchmesser bzw. verringerte Maulweite gebracht wird; gegebenenfalls mit überlappenden Stoßenden.

Das Verfahren bietet den Vorteil, dass die Eigenspannungen, die durch den Beschichtungsprozess in der aufgebrachten Verschleiß- und Korrosionsschutzschicht im Montagezustand des Kolbenringes im Zylinder entstehen, auf ein Minimum reduziert werden und damit ein Abschälen, Abblättern oder Rissbildung der Beschichtung vermieden wird. Insbesondere wird erreicht, dass die Festigkeit der Beschichtung unter Betriebsbedingungen bzw. bei der Montage der Kolbenringe in den Zylinder des Motors erhalten bleibt. Vorteilhafte Weiterbildungen sind Gegenstand der Unteransprüche.

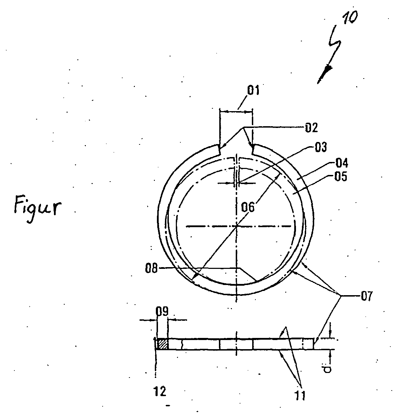

Die Erfindung wird im folgenden anhand eines Ausführungsbeispiels näher erläutert. Es zeigt die einzige Figur
eine schematische Darstellung eines Kolbenringes mit Verschleiß- oder Korrosionsschutzschicht in zwei Verformungszuständen

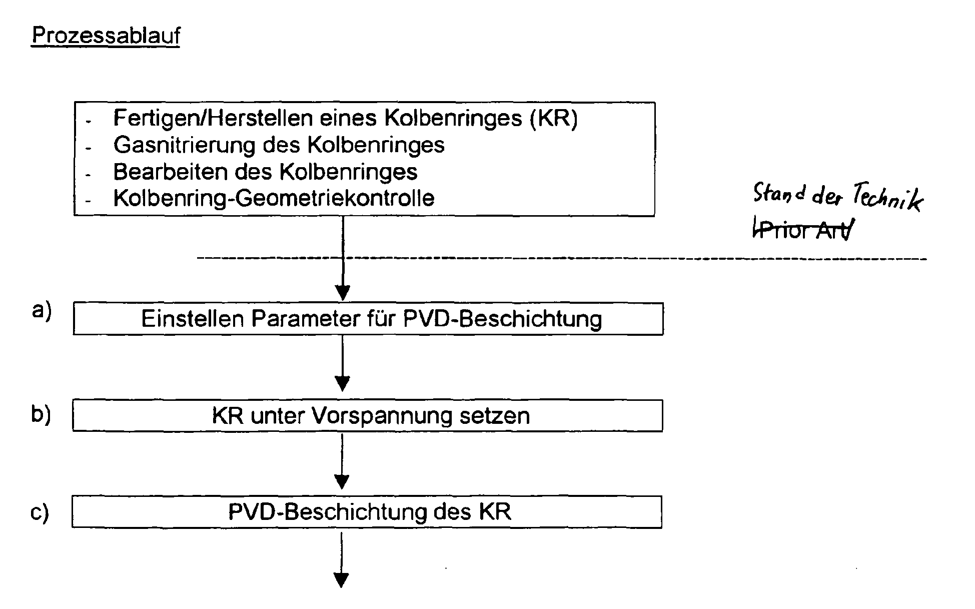

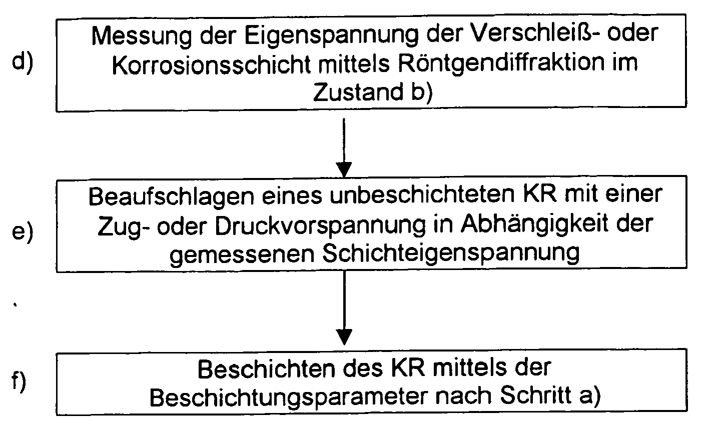

Wie aus dem vorgenannten Prozessablauf ersichtlich ist, wird ein in bekannter Weise durch Wickeln aus Draht, Abschneiden, Schleifen, Entspannungsglühen, Laufflächen- und Ringflankenbearbeitung hergestellter Kolbenring 10, der anschließend einem Gasnitrierprozess mit nachfolgender erneuter Laufflächen-, Ringflanken- und Stoßendenbearbeitung unterworfen wird, für das erfindungsgemäße Verfahren verwendet. Der derart auf seine geometrischen Abmessungen gebrachte Kolbenring 10 wird am äußeren Umfang mit einer im wesentlichen den Einbauzustand entsprechenden Zugvorspannung beaufschlagt, indem der Kolbenringdurchmesser 06 bzw. die Maulweite 01 des Kolbenringes 10 mittels einer mechanischen Druckvorrichtung auf ein der vorbestimmten Druckvorspannung entsprechendes Maß, hier 0,2 bis 0,3 mm gegenüber einen ungespannten Ring 04, eingestellt wird. Durch eine Klemmvorrichtung (nicht dargestellt), die den Kolbenring 10 über seine Ringflanken 11 klemmt, wird dieser entsprechend fixiert. Im anschließenden PVD-Beschichtungsprozess, der an sich bekannt und als zum Stand der Technik gehörig betrachtet wird, werden die Beschichtungsparameter, wie Vakuumdruck, Heiztemperatur- und Dauer, N₂ Gasfluss, Vorspannung und Kathodenstrom eingestellt. Mit derart festgelegten Beschichtungsparametern wird eine CrN- oder Cr₂N- oder TiN- Verschleiß- oder Korrosionsschutzschicht 12 in einer Schichtstärke von 28 bis 30 µm am gesamten Umfang auf die Lauffläche 07 des Kolbenringes 10 aufgebracht. Ebenso kann die Verschleiß- oder Korrosionsschutzschicht mittels eines ebenfalls an sich bekannten galvanischen Beschichtungsverfahrens erfolgen, wobei die Prozessparameter ebenfalls fixiert werden.

Nach dem Beenden der PVD- oder galvanischen Beschichtung wird mittels einer an sich bekannten Röntgendiffraktionsmessung, ohne dass der Kolbenring 10 aus seiner Klemmvorrichtung entnommen und damit entspannt wird, auf der dem Ringstoß gegenüberliegenden Laufflächenseite des Kolbenringes die Eigenspannung der aufgebrachten Schicht 12 bestimmt. Je nach dem ermittelten Eigenspannungswert - Druck- oder Zugeigenspannungen -, wird für die zu beschichtenden Kolbenringe die Maulweite 01 entsprechend vergrößert oder verkleinert. Eine Vergrößerung der Maulweite 01 des Kolbenringes 10 erfolgt mittels einer einfachen Spannvorrichtung, die in den Innendurchmesser des Kolbenringes eingeführt wird und diesen auf ein der vorbestimmten Zugvorspannung entsprechendes Maß auseinander drückt. Eine Verkleinerung der Maulweite 01 erfolgt mittels einer Spannvorrichtung, die den Außendurchmesser des Kolbenringes reduziert, wobei in einem weiteren Schritt der Kolbenring durch eine axiale Klemmvorrichtung in dieser Lage fixiert wird. Die Stoßenden können dabei auch, falls die gemessenen Schichteigenspannungen das erfordern, überlappend ausgeführt und fixiert werden.

Ein über seine Ringflanken 11 gestapelter Haufen unbeschichteter neu hergestellter Kolbenringe 10, deren Ringstöße 02 lagegleich übereinander liegend angeordnet sind, wird auf die der Schichteigenspannung entsprechende Maulweite 01 eingestellt und mittels der fixierten PVD-Beschichtungsparameter beschichtet.

Um optimale Schichteigenspannungen zu erreichen, mit denen ein Abblättern oder eine Rissbildung der Verschleiß- oder Korrosionsschutzschicht auf dem Kolbenring 10 wirksam vermieden werden kann, sollten diese, gemessen im Zustand des Einbaumaßes (gespannter Kolbenring), in einem Bereich von (minus) - 200 bis (minus) - 800 N/mm² liegen.

### Bezugszeichen

- Kolbenring: 10
- Maulweite: 01
- Ringstoß: 02
- Stoßspiel: 03
- ungespannter Ring: 04
- gespannter Ring: 05
- Durchmesser: 06
- Lauffläche: 07
- Ringrücken: 08
- radiale Wanddicke: 09
- Ringflanken: 11
- Verschleiß- oder Korrosionsschutzschicht: 12
- axiale Wanddicke (Höhe): d

## Patentansprüche

1. Verfahren zum Beschichten eines aus Stahl oder Gusseisen bestehenden Kolbenringes (10) für Verbrennungsmotoren, bei dem mindestens die Lauffläche (07) des Kolbenringes mit einer Verschleiß- oder Korrosionsschutzschicht (12) durch einen Ionenbeschichtungsprozess oder galvanigchen Prozess versehen wird,
**gekennzeichnet durch** die Merkmale:
a) Einstellen der Beschichtungsparameter;
b) Beaufschlagen eines unbeschichteten Kolbenringes (10) mit einer Vorspannung auf einen vorbestimmten Kolbenringdurchmesser (06) bzw. Maulweite (01);
c) Durchführung des Ionenbeschichtungsprozesses oder galvanischen Prozesses mit den Beschichtungs-parametern nach Schritt a);
d) Messen der bewirkten Schichteigenspannung der Verschleiß- oder Korrosionsschutzschicht (12) im Zustand b);
e) Beaufschlagen eines neuen, unbeschichteten Kolbenringes (10) mit einer Zug- oder Druckvorspannung in Abhängigkeit der gemessenen Schichteigenspannung, wobei bei einer gemessenen Druckeigenspannung der Verschleiß- oder Korrosionsschutzschicht der Kolbenring (10) beim Prozessschritt f) mit einer Druckvorspannung am Ringumfang und bei einer gemessenen Zugeigenspannung der Verschleiß- und Korrosionsschutzschicht (12) der Kolbenring (10) mit einer Zugvorspannung am Umfang beaufschlagt wird und
f) Beschichten des Kolbenringes (10) mittels der Beschichtungsparameter nach Schritt a).

2. Verfahren nach Anspruch 1, **dadurch gekennzeichnet, dass** die Schichteigenspannung der Verschleiß- und Korrosionsschutzschicht (12) nach der Beschichtung im montierten Zustand des Kolbenringes (10) im Zylinder eines Motors einen Wert von (minus) - 200 bis (minus) - 800 N/mm² aufweist.

3. Verfahren nach Anspruch 1, **dadurch gekennzeichnet, dass** die Beaufschlagung des Kolbenringes (10) mit der Zug- oder Druckvorspannung über die gesamte Dauer der Beschichtung erfolgt.

4. Verfahren nach Anspruch 1, **dadurch gekennzeichnet, dass** die Messung der Schichteigenspannung nach erfolgter Beschichtung mittels Röntgendiffraktion durchgeführt wird.

5. Verfahren nach Anspruch 4, **dadurch gekennzeichnet, dass** die Röntgendiffraktionsmessung gegenüber vom Ringstoß (02) erfolgt.

6. Verfahren nach Anspruch 1, **dadurch gekennzeichnet, dass** die Verschleiß- oder Korrosionsschutzschicht aus einer CrN- oder Cr₂N oder TiN- oder TiC-Verschleiß- oder Korrosionsschutzschicht (12) gebildet ist.

7. Verfahren nach Anspruch 1, **dadurch gekennzeichnet, dass** der Beschichtungsprozess ein PVD-Prozess ist.

8. Verfahren nach Anspruch 1, **dadurch gekennzeichnet, dass** der Beschichtungsprozess ein galvanischer Prozess ist.

## Claims

1. Method for coating a piston ring (10) for internal combustion engines made of steel or cast iron, in which at least the working surface (07) of the piston ring is provided with a wear resistant or corrosion protection coating (12) by means of an ion coating process or galvanic process,
**characterised by** the features:
a) adjusting the coating parameters;
b) prestressing an uncoated piston ring (10) to a predetermined piston ring diameter (06) or opening size (01);
c) conducting the ion coating process or galvanic process using the coating parameters according to step a);
d) measuring the resultant inherent stress of the wear-resistant or corrosion protection layer (12) in condition b);
e) pressurising a new, uncoated piston ring (10) with tensile or pressure prestressing depending on the measured inherent stress of the coating, whereby with a measured inherent stressing of the wear or corrosion protection layer the piston ring (10) is prestressed at the ring circumference during process step f), and in the case of a measured inherent tensile loading of the wear resistant and corrosion protection layer (12) the piston ring (10) is pressurised by tensile preloading on the circumference and f) coating the piston ring (10) by means of the coating parameters according to step a).

2. Method according to claim 1, **characterised in that** the inherent coating stress of the wear resistant and corrosion protection coating (12) has a value of (minus) -200 to (minus) -800 N/mm² after being coated in the assembled state of the piston ring (10) in the cylinder of an engine.

3. Method according to claim 1, **characterised in that** the application of tensile or pressure prestressing to the piston ring (10) takes place over the entire duration of the coating process.

4. Method according to claim 1, **characterised in that** after the coating process has taken place the measurement of the inherent coating stress is performed by means of X-ray diffraction.

5. Method according to claim 4, **characterised in that** the X-ray diffraction measurement takes place opposite the ring joint (02).

6. Method according to claim 1, **characterised in that** the wear resistant or corrosion protection coating is formed from a CrN or Cr₂N or TiN or TiC wear resistant or corrosion protection coating (12).

7. Method according to claim 1, **characterised in that** the coating process is a PVD process.

8. Method according to claim 1, **characterised in that** the coating process is a galvanic process.

## Revendications

1. Procédé d'application d'un revêtement sur un segment de piston (10) composé d'acier ou de fonte pour moteurs à combustion interne, dans lequel au moins la portée (07) du segment de piston est munie d'une couche de protection contre l'usure ou la corrosion (12) par un processus de revêtement ionique ou un processus galvanique,
**caractérisé par** les caractéristiques :
a) réglage des paramètres d'application ;
b) sollicitation d'un segment de piston (10) non revêtu par une précontrainte à un diamètre (06) ou ouverture (01) de segment de piston prédéfinis ;
c) mise en oeuvre du processus de revêtement ionique ou du processus galvanique avec les paramètres d'application suivant la phase a) ;
d) mesure de la contrainte propre provoquée de la couche de protection contre l'usure ou la corrosion (12) dans l'état b) ;
e) sollicitation d'un nouveau segment de piston (10) non revêtu par une précontrainte de traction ou de compression en fonction de la contrainte propre de couche mesurée, le segment de piston (10) étant sollicité dans la phase de processus f) par une précontrainte de compression sur son pourtour pour une contrainte propre de compression mesurée de la couche de protection contre l'usure ou la corrosion et le segment de piston (10) étant sollicité par une précontrainte de traction sur son pourtour pour une contrainte propre de traction mesurée de la couche de protection contre l'usure ou la corrosion (12) et
f) revêtement du segment de piston (10) au moyen des paramètres d'application suivant la phase a).

2. Procédé suivant la revendication 1, **caractérisé en ce que** la contrainte propre de la couche de protection contre l'usure et la corrosion (12) présente après l'application du revêtement, dans l'état de montage du segment de piston (10) dans le cylindre d'un moteur, une valeur de (moins) - 200 à (moins) - 800 N/mm².

3. Procédé suivant la revendication 1, **caractérisé en ce que** la sollicitation du segment de piston (10) par la précontrainte de traction ou de compression s'effectue sur toute la durée d'application du revêtement.

4. Procédé suivant la revendication 1, **caractérisé en ce que** la mesure de la contrainte propre de la couche est effectuée par diffraction des rayons X après l'application du revêtement.

5. Procédé suivant la revendication 4, **caractérisé en ce que** la diffractométrie à rayons X s'effectue en vis-à-vis de la coupe de segment de piston (02).

6. Procédé suivant la revendication 1, **caractérisé en ce que** la couche de protection contre l'usure ou la corrosion est formée d'une couche (12) CrN ou Cr₂N ou TiN ou TiC.

7. Procédé suivant la revendication 1, **caractérisé en ce que** le processus d'application du revêtement est un processus PVD.

8. Procédé suivant la revendication 1, **caractérisé en ce que** le processus d'application du revêtement est un processus galvanique.
